# EUROPEAN PATENT APPLICATION

(11) **EP 0 881 310 A1**
(43) Date of publication of application: **02.12.1998**
(21) Application number: 98201627.1
(22) Date of filing: 15.05.1998
(51) Int. Cl.: C23C 14/04, F21V 3/04

(54) **Process for the manufacture of a lighting globe with metalized inner surface**

(30) Priority: 21.05.1997 IT MI971183
(71) Applicant: Industrie de Zorzi s.r.l., 20060 Liscate, (Milano) (IT)
(72) Inventor: De Zorzi, Mario, 20096 Pioltello, (Milano) (IT); Arzuffi, Danilo, 20043 Arcore, (Milano) (IT)
(74) Representative: Mittler, Enrico

(57) **Abstract**

The process for the manufacture of a lighting globe with metalized cap is described, by which metalization (8) of the cap (7) is obtained by controlled vacuum deposition of a metal (6) or an oxide thereof inside the globe (1). A lighting globe (1) with cap (7) provided with internal metalization (8) is thus obtained.

## Description

The present industrial invention refers to a process for the manufacture of a lighting globe with metalized cap, as well as to the product thus obtained.

In lighting technology there are known diffusers shaped as a globe, made of glass or transparent plastic material, that have an upper cap externally coated or metalized in such a way as to assume a reflecting and not light transparent appearance.

The caps of the known globes show various inconveniences connected with the external coating of the cap itself. Indeed, the coating material is subject to chemical and mechanical abrasions, as also to the attack of atmospheric agents and of the corrosive excrements of birds. This has a negative effect on the durability of the product.

In view of this state of the art, object of the present invention has been to realise a process for the manufacture of a lighting globe with metalized cap which would give rise to a finished product free of the aforementioned inconveniences.

According to the invention, such object has been attained with a process characterised in that metalization of the transparent globe cap is obtained by controlled vacuum deposition of a metal or an oxide thereof, inside the globe itself.

More precisely, the globe to be subjected to treatment is placed inside a vacuum chamber and the sublimation of an appropriate metal or of one of its oxides is effected inside the globe.

The area to be treated can be delimited through a masking technique on the part of the globe that is not to be treated or through subsequent removal of the metalization in excess by means of an appropriate chemical process.

In this way a lighting globe having an internally instead of externally coated cap is provided. This has the effect of making the same cap totally free of any risks of chemical or mechanical abrasion, atmospheric agent attacks, corrosive action of bird excrements; this results into a considerably increased durability of the cap, and in general of the globe, and the brightness is maintained almost unaltered through time. In addition the cap thus obtained confers a quite characteristic global appearance, different from the one of the globes with cap metalized from the outside.

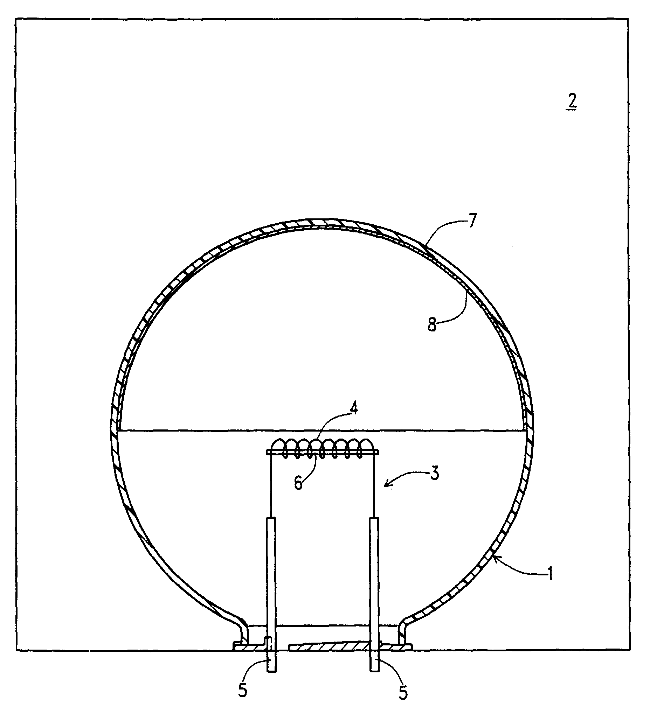

A possible embodiment of the process according to the invention will be now described as a non-limiting example with reference to the enclosed drawing, that shows a lighting globe during treatment.

In the drawing, a lighting globe 1 of transparent plastic material, previously formed by means of a technique known per se, is placed inside a treatment chamber 2, for example a pressure accumulator, maintained under high vacuum.

A sublimation device 3 is placed inside the globe, the device being composed substantially of an electric coil 4, for example of tungsten, which is brought to incandescence through a couple of terminals 5.

In proximity to the incandescent coil a bar or plate or any other piece 6 of metal or metal oxide is placed, which, as an effect of the very high temperature of the coil and of the high vacuum created inside the treatment chamber, undergoes a process of sublimation and deposition on the internal surface of the globe.

The treatment area can be delimited by previously applying an internal mask or by removing chemically the part of metalization in excess.

The globe 1 is thus provided with a cap 7 having an internal metalization 8 with a reflecting appearance, non-transparent to direct or dichroic light.

## Claims

1. Process for the manufacture of a lighting globe with metalized cap characterised in that metalization (8) of the cap (7) is obtained by controlled vacuum deposition of a metal (6) or an oxide thereof inside the globe (1).

2. Process according to claim 1, characterised in that it comprises introduction of the globe (1) inside a vacuum treatment chamber (2) and insertion of a sublimation device (3) for a metal (6) or an oxide thereof inside the globe (1).

3. Process according to claim 1, characterised in that the area of treatment of the internal surface of the globe (1) is delimited by means of a masking technique on the part of the globe which is not to be treated.

4. Process according to claim 1, characterised in that the area of treatment of the internal surface of the globe (1) is delimited by chemical removal of the part of metalization in excess.

5. Lighting globe with metalized cap, characterised in that said cap (7) is provided with an internal metalization (8).
